# EUROPEAN PATENT SPECIFICATION

(11) **EP 0 777 236 B1**
(45) Date of publication and mention of the grant of the patent: **20.03.2002**
(21) Application number: 96118947.9
(22) Date of filing: 27.11.1996
(51) Int. Cl.: G11C 29/00

(54) **Method and circuit for testing semiconductor memory units**
Verfahren und Vorrichtung zur Prüfung von Halbleiterspeichervorrichtungen
Procédé et circuit pour tester des dispositifs de mémoire à semi-conducteurs

(30) Priority: 29.11.1995 US 7674
(43) Date of publication of application: 04.06.1997
(73) Proprietor: TEXAS INSTRUMENTS INCORPORATED, Dallas, Texas 75243 (US)
(72) Inventor: Cline, Danny R., Plano, TX 75094 (US)
(74) Representative: Mather, Belinda

(56) References cited:
- EP-A- 0 314 924
- JP-A- 5 325 599
- US-A- 5 367 492
- COMPUTER, vol. 12, no. 10, October 1979, LONG BEACH US, pages 23-31, XP002028113 CRAFTS J. M. ET AL.: "Techniques of memory testing"
- IBM TECHNICAL DISCLOSURE BULLETIN, vol. 32, no. 12, May 1990, NEW YORK US, pages 321-323, XP000105384 "Flexible address pattern generator for a memory tester"

## Description

### BACKGROUND OF THE INVENTION

### FIELD OF THE INVENTION

This invention relates generally to semiconductor memory units implemented in integrated circuit technology and, more particularly, to the addressing, during test procedures, of memory cells in arrays having a complex topology.

### DESCRIPTION OF THE RELATED ART

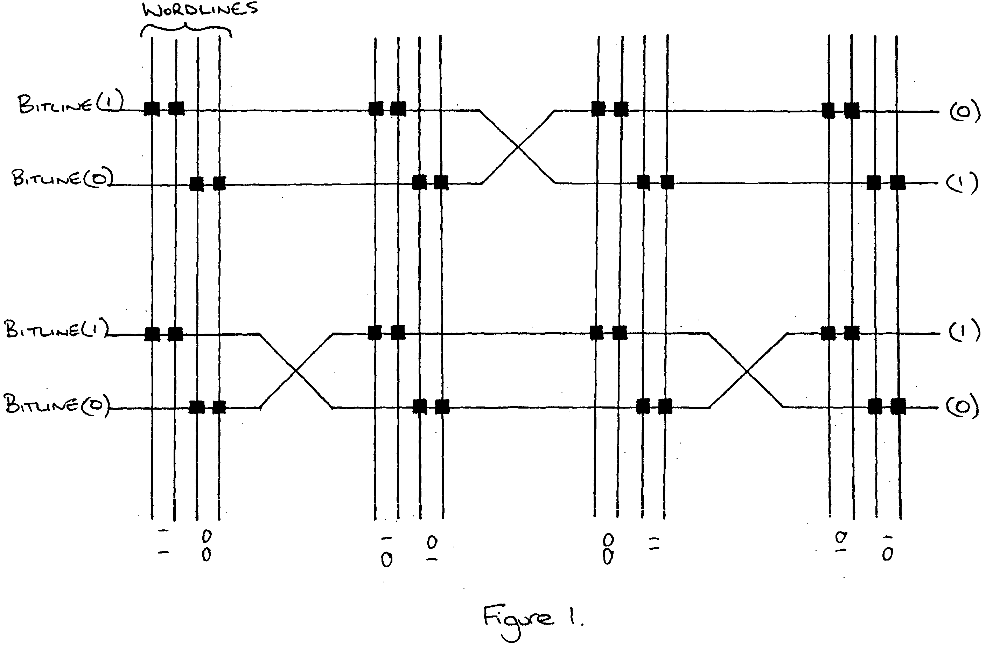

In the prior art, the semiconductor array topologies were relatively simple grid patterns. Test patterns could be written into the storage cell array with relatively simple row-copy write techniques. With the introduction of complex array topologies, as a result for example of twisted bitlines and scramble logic, the use of row copy techniques for test procedures was no longer viable. Referring to Fig. 1, an array of storage cells 11 is shown in which the bitlines are twisted. As a result, the stored logic states, indicated at the bottom of the wordlines, are different even though configurations appear to be the same. Therefore, the activation of the storage cells to form selected memory cell storage patterns is more complicated than can be accommodated by the row copy techniques of the prior art. In the row copy techniques, a given wordline is accessed and the sense amplifiers write data back into the cell. The sense amplifiers continue to be driven while the row address is changed resulting in the storage of same data pattern. Because the row copy techniques can not be employed, a longer semiconductor memory test time is required and, in the past, has required external testing apparatus.

A need has therefore been felt for test apparatus and an associated method which would provide fast and efficient storage of internal data patterns in the semiconductor memory storage cell array. The apparatus should be capable of the storage of preselected test patterns in storage cell arrays with complex addressing topologies, such as is found with twisted bitlines. The patterns are difficult to implement and time consuming when prior art techniques are used.

### SUMMARY OF THE INVENTION

The invention provides a memory unit comprising a storage cell array having a plurality of storage cells; a pattern storage unit for storing data pattern groups; a data input/output unit for exchanging data with an addressed group of storage cells; and characterised by comprising: an addressing unit for addressing groups of said storage cells said addressing unit including apparatus for addressing at least a first non-sequential series of storage cell groups in response to a first address control signal, wherein a first data pattern group is stored in said non-sequential series of storage cell groups in response to a first write control signal.

The aforementioned features are accomplished, according to the present invention, by providing a memory unit with a ROM pattern unit for storing data pattern groups, a variable step address generator unit, a comparator unit, and a control unit. A data group pattern from the ROM pattern unit is used as a template for the storage of each data group pattern in the storage cell array. The variable step address generator permits the template data group pattern to be entered at each appropriate, periodic address in a row copy procedure, the periodicity being determined by the topology of the storage cell array. When the array storage cell data pattern is complete, the variable step address generator retrieves each data pattern group from periodic addresses of the storage cell array and compares the retrieved data pattern with the template data pattern group stored in the ROM pattern unit. Comparison errors can be stored in order to provide remedial corrective activity.

The features of the present invention will be understood upon the reading of the Specification in conjunction with the Figures.

### BRIEF DESCRIPTION OF THE DRAWINGS

The present invention will now be further described, by way of example, with reference to the accompanying drawings in which:-
Figure 1 is an illustration of the complexity of stored logic signal arrays for a twisted bitline; and
Figure 2 is block diagram of a memory unit including the test apparatus according to the present invention.

### DETAILED DESCRIPTION OF THE DRAWINGS

Fig. 1 has been discussed with reference to the prior art.

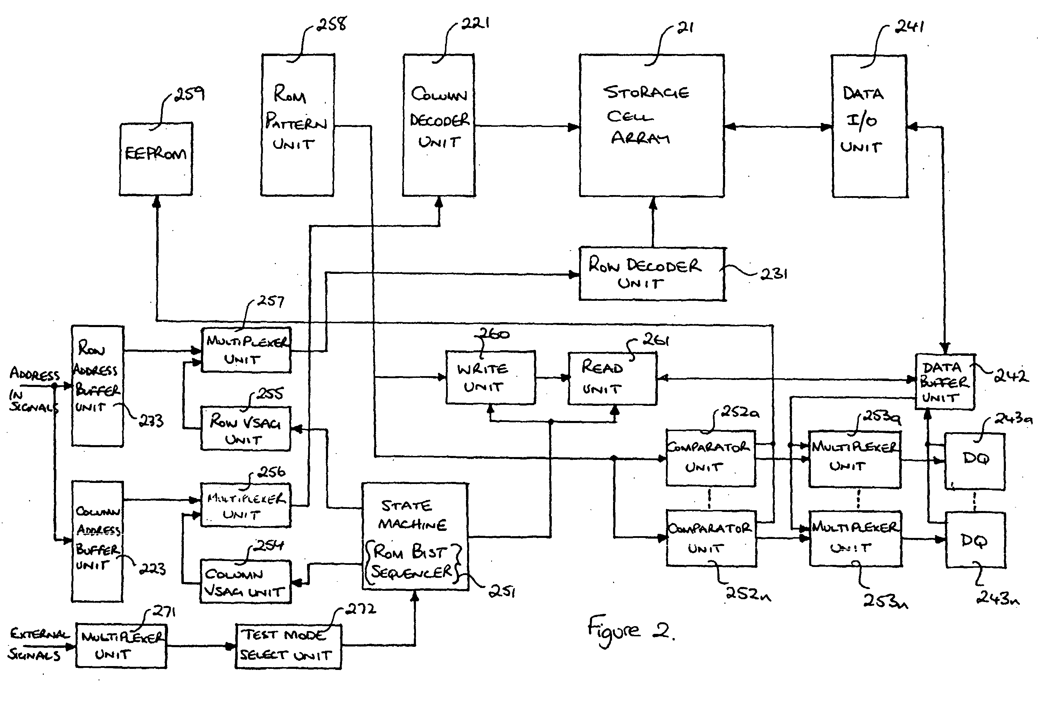

Referring to Fig. 2, the schematic block diagram of a semiconductor memory unit according to the present invention is shown. The storage cell array 21 includes the storage cells used in the storage of signals representing logic states as well as associated apparatus, such as the sense amplifiers, needed for the operation of the storage cell array. The column decoder unit 221 and the row decoder unit 231 specify, in response to ADDRESS IN signals, the locations of the storage cell array currently being accessed. The data I/O unit 241 supplies data signals to and retrieves data signals from the addressed cells in the storage cell array 21. The data buffer unit 242 is coupled to the data I/O unit 241 and is coupled to the memory data terminals 243a through 243n. The row decoder unit 231 is coupled to the multiplexer unit 257, while the column decoder unit 221 is coupled to multiplexer unit 256. The multiplexer unit 257 is coupled to row VSAG (variable step address generator) 255 and to row address buffer unit 233. The multiplexer unit 256 is coupled to column VSAG unit 254 and to column address buffer unit 223. The row address buffer unit 233 and the column address buffer unit 223 have ADDRESS IN signals applied thereto. The output terminals of multiplexer units 253a through 253n are coupled to data terminals 243a through 243n, respectively. Input terminals of multiplexer units 253a through 253n are coupled to first output terminals of comparator units 252a through 252n, respectively, and to data buffer unit 242. Second output terminals of comparator units 252a through 252n are coupled to EEPROM (electrically erasable programmable read only memory) unit 259, while first input terminals of comparator units 252a through 252n are coupled to read unit 261 and second input terminals of comparator units 252a through 252n are coupled to ROM pattern unit 253. The ROM pattern unit 258 is also coupled to an input terminal of write unit 260. An output terminal of write unit 260 is coupled to read unit 261. The read unit 261 is coupled to data buffer unit 242. EXTERNAL signals are applied to a first input terminal of multiplexer unit 271. An output terminal of multiplexer unit 271 is applied to test mode select unit. 272. An output terminal of test mode select unit 272 is coupled to an input terminal of state machine (or ROM BIST {built in self test} unit) 251. State machine 251 has output terminals coupled to multiplexer unit 271, row VSAG unit 255, column VSAG unit 254, to write unit 260 and to read unit 261. The state machine 251 supplies control signals to other units, such as the multiplexer unit, to implement the normal memory operation or the memory test operation, whichever is currently being executed.

### OPERATION OF THE PREFERRED EMBODIMENT(S)

In testing a memory unit, the first step is to define the desired test pattern. For example, if the effect on a storage cell of nearest neighbors is to be determined, a pattern wherein a storage cell storing the first logic state is surrounded by nearest neighbors having a complementary logic state can be generated. In order to provide a background test pattern, an understanding of the address scrambling, which is usually device specific, is required. The sense amplifier, implemented with a differential amplifier, will drive a data line pair, generally referred to as bitline and bitline_, to opposite states. The storage cell then stores the value of the bitline or the bitline_. The storage cell is connected to the transfer device and the transfer device is activated by a signal on the wordline.

To generate the desired pattern, the sense amplifiers can be set and a signal asserted on the selected wordline. The wordlines will alternate connectivity to the different bitline storage cell combinations. A variable step address generator VSAG, also known a variable indexing unit, is used to skip alternating patterns to compensate for bitline and bitline_ connectivity and bitline twist. With the complexity of the bitline twist topography (implemented for purposes of noise reduction in the memory cell), and with the bitline or bitline_ connectivity to the storage cells, it is difficult to transfer data patterns efficiently into the storage cell array without experiencing data inversion resulting from a wordline increment causes storage cell access to switch between the bitline and the bitline_ topology. However, the patterns will repeat as a function of the array topology. The variable step address generator, in combination with the state control logic unit can be used to copy array fill patterns much more efficiently using a row copy procedure with non-sequential address steps.

Once the preselected storage cell array pattern has been entered, then a read and compare cycle is used to test the stored data using the appropriate pattern from the ROM pattern memory. The variable step address generator selects the correct stored pattern and is synchronized with the row address for the current cycle.

This mode of operation allows the row copy procedure to be used in situations where the more complex storage cell array topology has made the prior art procedures inappropriate.

Using this procedure, data patterns typically run in a functional test mode but can be run in a self-test mode. The test mode operation can be run automatically in a sequential manner during power up or can be run individually by a selectable entry test key (i.e., an address entry key).

The state machine (with built in self test machine) controls the sequence of operations during the test procedure. The variable step address generator is incorporated into the normal address decoding path to take care of the non-sequential internal address decoding during the test. Results from the test can be written directly to the output terminals and also can be stored in an EEPROM memory. The EEPROM memory offers the advantage of incorporating self repair by testing for bad rows or columns. The failures can be recorded and the correct repair address stored in the look-up table. The capability allows on-line built in self testing or a concurrent built-in self testing.

Referring once again to Fig. 2, the patterns required for testing are stored in ROM pattern unit 258. When a EXTERNAL signal or internal condition results in the selection of test mode, i.e., by the test mode select unit 272, a signal (or group of signals) is applied to the state machine 251. The state machine applies control signals to the row VSAG unit 255, to the column VSAG unit 254, to the write unit 260, to the read unit 261 and to the ROM pattern unit 258. As a result of these and other control signals, a data pattern group from the ROM pattern unit 258 is stored in the data buffer unit 242. The first data pattern stored in the data buffer unit 242 is entered as a first group of addresses determined by the row VSAG unit and the column VSAG unit. The first group of addresses, determined by the first data pattern and the topology of the storage cell array, will store the first data pattern at the addresses which will result in the desired array pattern. Next a second data pattern from the ROM pattern unit 258 will be stored in the data buffer unit and the pattern stored in the storage cell array at a second group of addresses determined by the row VSAG unit 255 and the column VSAG unit 254. The storage of the successive data pattern groups (at successive address groups determined by the data pattern) will fill the storage cells of the storage cell array with the desired array pattern.

The state machine 251 now enters the comparison mode wherein control signals are provided resulting in extraction of a first stored data pattern group at addresses determined by the row VSAG unit 255 and the column VSAG unit 254. The retrieved first stored data patterns are compared against the data pattern in the ROM pattern unit 258 which was used as template for the first stored data patterns. The comparison is performed in the comparison unit 252a through 252n and stored in the EEPROM unit 259 and/or applied to the memory unit output terminals 243a through 243n. Each set of stored data groups is retrieved and compared with the template data group in the ROM pattern unit 258. In this manner each location of the memory cell array can be tested. The use of a sequence of addresses from the row VSAG unit 255 and the column VSAG unit 254 permits a modified row copy mode, each of the plurality of copied data patterns not generally being copied in consecutive rows.

The storage of detected test faults in the EEPROM unit 259 can permit the memory unit to provide a self correction mechanism or these results can be retrieved after completion of the test procedure. As the memory units have become larger, the testing has required a longer period of time. Using external testing apparatus would, because of the increasing time required for testing, increase the cost by an appreciable amount either because of the number of test stations required or because of the time required for testing in a limited number of test stations. The provision for self testing by the memory units, eliminates the need for testing apparatus and the potential bottlenecks involving such apparatus as the size and complexity of the memory unit arrays increases.

While the invention has been described with particular reference to the preferred embodiment, it will be understood by those skilled in the art that various changes may be made and equivalents substituted for elements of the preferred embodiment without departing from the invention. In addition, many modifications may be made to adapt a particular situation and material to a teaching of the present invention without departing from the essential teachings of the present invention.

As is evident from the foregoing discussion, certain aspects of the invention are not limited to the particular details of the examples illustrated, and it is therefore contemplated that other modifications and applications will occur to those skilled in the art.

## Claims

1. An memory unit comprising:
a storage cell array (21) having a plurality of storage cells;
a pattern storage unit (258) for storing data pattern groups;
a data input/output unit (241) for exchanging data with an addressed group of storage cells;
an addressing unit for addressing groups of said storage cells and **characterised in that** : said addressing unit includes apparatus for addressing at least a first non-sequential series of storage cell groups in response to a first address control signal, wherein a first data pattern group is stored in said non-sequential series of storage cell groups in response to a first write control signal.

2. The memory unit of claim 1 further comprising a comparison unit (252a,...252n) for comparing said first data pattern group stored in said storage cell array with a first data pattern group stored in said pattern storage unit in response to a first read control signal.

3. The memory unit of Claim 1 or Claim 2, further comprising a storage unit storing data signals indicating when said first data pattern group stored in said storage cell array is not equal to said first data pattern group in said pattern storage unit.

4. The memory unit of any preceding claim, wherein a second data pattern group is stored in a second non-sequential storage cell group in response to a second write control signal.

5. The memory unit of any preceding claim, wherein said apparatus for addressing includes a variable step address generator (254, 255) and wherein said pattern storage unit is a ROM unit (258).

6. The memory unit of any preceding claim further comprising; a state machine (251) for providing said first address control signal, said first write control signal, and said first read control signal.

7. The memory unit of any preceding claim, wherein said storage cell array has a complex topology including twisted bitline pairs.

8. The memory unit of any preceding claim, wherein the memory unit is a random access memory (RAM) unit.

9. The memory unit according to any preceding claim, in which said addressing unit comprises a row and column addressing unit (233, 223) for addressing row storage cells; and
an auxiliary addressing unit (254, 255) responsive to addressing control signals for addressing a series of non-sequential storage cell array groups.

10. The memory unit according to any preceding claim further comprising:
a control unit (251) for providing said addressing control signals having a test mode to cause a stored data group to be entered in a preselected series of non-sequential storage cell array groups.

11. The memory unit of claim 10 further comprising: a comparison unit (252) coupled to said data I/O unit (241) and said pattern storage unit (258), said control unit (251) having a second test mode for providing a retrieval of stored data groups from a series of non-sequential storage cell array groups and comparing of said retrieved data groups with the pattern data group originally stored in said series of non-sequential storage cell array groups.

12. The memory unit of claim 10 or claim 11, wherein a plurality of said series of non-sequential storage cell array groups in combination with a plurality of data pattern groups permit said storage cell array to be filled with a preselected array pattern.

13. The memory unit of any of claim 11 or claim 12, further comprising: a comparison storage unit (259) for storing results of said comparison.

14. The memory unit of any of Claims 11 to 14, wherein said auxiliary addressing unit includes a variable step address generator.

15. A method for providing a given storage cell array in a memory unit with a preselected data pattern group, the method comprising:
storing in a sub-unit of said memory unit data pattern groups comprising said preselected data pattern group; and
applying each of said data pattern groups to a non-sequential series of storage cell group addresses.

16. The method of claim 15 further comprising;
retrieving each of said data pattern groups from each of said non-sequential series of storage cell group addresses; and
comparing each retrieved data pattern group with a data pattern group in said sub-unit stored at the storage cell group address.

17. Test apparatus for testing a memory unit having a storage cell array having a plurality of storage cell groups and a data input/output unit for exchanging data with an addressed group of cells, said test apparatus **characterised by** comprising:
a pattern memory unit (258) for storing a first plurality of data pattern groups;
an addressing unit for addressing a second plurality of non-sequential storage cell groups, wherein data pattern groups stored in associated storage cell groups permit a preselected data pattern or portion thereof to be entered in said storage cell array of said memory unit.

18. The test apparatus of Claim 17 further comprising a comparison unit (252) for comparing a selected pattern memory group with data pattern groups retrieved by said addressing unit from storage cell groups into which said selected pattern had been stored.

19. The test apparatus of claim 18, further comprising: a comparison storage unit (259) for storing results received from said comparison unit (252).

20. The test apparatus of any of Claims 17 to 19, wherein said addressing unit includes a variable step address generator (254, 255).

21. The test apparatus of any of Claims 17 to 20, wherein the test apparatus is formed integrally with a memory unit.

## Patentansprüche

1. Speichereinheit mit:
einer Speicherzellenanordnung (21) mit einer Mehrzahl von Speicherzellen,
einer Musterspeichereinheit (258) für das Speichern von Gruppen von Datenmustern,
einer Dateneingabe/Ausgabeeinheit (241) für den Austausch von Daten mit einer adressierten Gruppe von Speicherzellen,
einer Adressiereinheit für das Adressieren von Gruppen der Speicherzellen, **dadurch gekennzeichnet, daß** die erste Adressiereinheit eine Vorrichtung zum Adressieren von zumindest einer ersten, nicht sequentiellen Serie von Speicherzellgruppen in Reaktion auf ein erstes Adreßsteuersignal aufweist, wobei eine erste Datenmustergruppe in Reaktion auf ein erstes Schreibesteuersignal in der nicht sequentiellen Reihe von Speicherzellgruppen gespeichert wird.

2. Speichereinheit nach Anspruch 1, welche weiterhin eine Vergleichseinheit (52a, ...252n) für das Vergleichen der ersten Datenmustergruppe, die in der Speicherzellenanordnung gespeichert ist, mit einer ersten Datenmustergruppe, die in der Musterspeichereinheit in Reaktion auf ein erstes Lesesteuersignal gespeichert ist, aufweist.

3. Speichereinheit nach Anspruch 1 oder 2, welche weiterhin eine Speichereinheit aufweist, die Datensignale speichert, welche anzeigen, wenn die erste in der Speicherzellanordnung gespeicherte Datenmustergruppe nicht gleich der ersten Datenmustergruppe in der Musterspeichereinheit ist.

4. Speichereinheit nach einem der vorstehenden Ansprüche, wobei eine zweite Datenmustergruppe in Reaktion auf ein zweites Schreibesteuersignal in einer zweiten, nicht sequentiellen Speicherzellgruppe gespeichert ist.

5. Speichereinheit nach einem der vorstehenden Ansprüche, wobei die Vorrichtung zum Adressieren einen Adreßgenerator (254, 255) mit variablem Schritt aufweist und wobei die Musterspeichereinheit eine ROM-Einheit (258) ist.

6. Speichereinheit nach einem der vorstehenden Ansprüche, welche weiterhin eine Zustandsmaschine (251) aufweist, um das erste Adreßsteuersignal, das erste Schreibsteuersignal und das erste Lesesteuersignal bereitzustellen.

7. Speichereinheit nach einem der vorstehenden Ansprüche, wobei die Speicherzellanordnung eine komplexe Topologie einschließlich verdrillter Bitleitungspaare hat.

8. Speichereinheit nach einem der vorstehenden Ansprüche, wobei die Speichereinheit ein Speicher mit wahlweisem Zugriff (RAM) ist.

9. Speichereinheit nach einem der vorstehenden Ansprüche, wobei die Adressiereinheit eine Zeilen- und Spaltenadreßeinheit (233, 223) für das Adressieren von Reihenspeicherzellen aufweist, sowie
eine Hilfsadressiereinheit (254, 255), die auf Adreßsteuersignale anspricht, um eine Serie von nicht sequentiellen Speicherzellgruppen der Anordnung zu adressieren.

10. Speichereinheit nach einem der vorstehenden Ansprüche, welche weiterhin aufweist:
eine Steuereinheit (251), um die Adreßsteuersignale bereitzustellen, welche einen Testbetrieb haben, um zu veranlassen, daß eine gespeicherte Datengruppe in eine vorgewählte Serie nicht sequentieller Speicherzellgruppen des Arrays eingetragen wird.

11. Speichereinheit nach Anspruch 10, welche weiterhin aufweist:
eine Vergleichseinheit (252), die mit der Daten-I/O-Einheit (241) und der Musterspeichereinheit (258) verbunden ist, wobei die Steuereinheit (251) einen zweiten Testbetriebszustand hat, um ein Wiedergewinnen von gespeicherten Datengruppen aus einer Serie von nicht sequentiellen Speicherzellgruppen des Arrays bereitzustellen und die wiedergewonnenen Datengruppen mit den Musterdatengruppen zu vergleichen, welche ursprünglich in der Serie von nicht sequentiellen Speicherzellgruppen gespeichert wurden.

12. Speichereinheit nach Anspruch 10 oder 11, wobei eine Mehrzahl der Serie von nicht sequentiellen Speicherzellgruppen des Arrays in Verbindung mit einer Mehrzahl von Datenmustergruppen ermöglichen, daß das Speicherzellarray mit einem vorgewählten Arraymuster gefüllt wird.

13. Speichereinheit nach einem der Ansprüche 11 oder 12, welche weiterhin aufweist:
eine Vergleichsspeichereinheit (259) für das Speichern von Ergebnissen des Vergleichs.

14. Speichereinheit nach einem der Ansprüche 11 bis 13,wobei die Hilfsadressiereinheit einen Adreßgenerator mit variablem Schritt (variabler Schrittlänge) aufweist.

15. Verfahren zum Bereitstellen einer gegebenen Speicherzellanordnung in einer Speichereinheit mit einer vorgewählten Datenmustergruppe, wobei das Verfahren aufweist:
Speichern von Datenmustergruppen, welche dir vorgewählte Datenmustergruppe aufweisen in einer Untereinheit der Speichereinheit und Aufbringen jeder der Datenmustergruppen auf eine nicht sequentielle Serie von Adressen von Speicherzellgruppen.

16. Verfahren nach Anspruch 15, welches weiterhin aufweist:
Wiedergewinnen jeder der Datenmustergruppen aus jeder der nicht sequentiellen Serie von Adressen von Speicherzellgruppen und
Vergleichen jeder wiedergewonnenen Datenmustergruppe mit einer Datenmustergruppe in der Untereinheit, die unter der Adresse der Speicherzellgruppe gespeichert ist.

17. Testvorrichtung zum Überprüfen einer Speichereinheit mit einer Speicherzellanordnung, welche eine Mehrzahl von Speicherzellgruppen hat, sowie eine Dateneingabe/Ausgabeeinheit für den Austausch von Daten mit einer adressierten Gruppe von Zellen, wobei die Testvorrichtung **dadurch gekennzeichnet ist, daß** sie aufweist:
eine Musterspeichereinheit (258), um eine erste Mehrzahl von Datenmustergruppen zu speichern,
eine Adressiereinheit für das Adressieren einer zweiten Mehrzahl von nicht sequentiellen Speicherzellgruppen, wobei Datenmustergruppen, die in zugehörigen Speicherzellgruppen gespeichert sind, ermöglichen, daß ein vorgewähltes Datenmuster oder ein Teil hiervon in die Speicherzellanordnung der Speichereinheit eingetragen wird.

18. Testvorrichtung nach Anspruch 17, welche weiterhin eine Vergleichseinheit (252) für das Vergleichen ausgewählter Musterspeichergruppen mit Datenmustergruppen aufweist, die durch die Adressiereinheit aus den Speicherzellgruppen wiedergewonnen wurden, in welchen das ausgewählte Muster gespeichert worden war.

19. Testvorrichtung nach Anspruch 18, welche weiterhin eine Vergleichsspeichereinheit (259) aufweist, um aus der Vergleichseinheit (252) empfangene Ergebnisse zu speichern.

20. Testvorrichtung nach einem der Ansprüche 17 bis 19, wobei die Adressiereinheit einen Adreßgenerator (254, 255) mit variablem Schritt (variabler Schrittweite) aufweist.

21. Testvorrichtung nach einem der Ansprüche 17 bis 20, wobei die Testvorrichtung einstückig mit einer Speichereinheit ausgebildet ist.

## Revendications

1. Unité de mémoire comportant:
une matrice (21) de cellules de stockage ayant une pluralité de cellules de stockage;
une unité (258) de stockage de motifs destiné à stocker des groupes de motifs de données;
une unité ' (241) d'entrée/sortie de données destinée à échanger des données avec un groupe adressé de cellules de stockage;
une unité d'adressage destinée à l'adressage de groupes desdites cellules de stockage, et **caractérisée en ce que** ladite unité d'adressage comprend un dispositif pour l'adressage d'au moins une première série non séquentielle de groupes de cellules de stockage en réponse à un premier signal de commande d'adresse, un premier groupe de motifs de données étant stocké dans ladite série non séquentielle de groupes de cellules de stockage en réponse à un premier signal de commande d'écriture.

2. Unité de mémoire selon la revendication 1, comportant en outre une unité de comparaison (252a,...252n) destinée à comparer lesdits premiers groupes de motifs de données stockés dans ladite matrice de cellules de stockage à un premier groupe de motifs de données stocké dans ladite unité de stockage de motifs en réponse à un premier signal de commande de lecture.

3. Unité de mémoire selon la revendication 1 ou la revendication 2, comportant en outre une unité de stockage stockant des signaux de données indiquant lorsque ledit premier groupe de motifs de données stocké dans ladite matrice de cellules de stockage n'est pas égal audit premier groupe de motifs de données dans ladite unité de stockage de motifs.

4. Unité de mémoire selon l'une quelconque des revendications précédentes, dans laquelle le second groupe de motifs de données est stocké dans un second groupe de cellules de stockage non séquentiel en réponse à un second signal de commande d'écriture.

5. Unité de mémoire selon l'une quelconque des revendications précédentes, dans laquelle ledit dispositif pour l'adressage comprend un générateur (254, 255) d'adresse de pas variable et dans lequel ladite unité de stockage de motifs est une unité à mémoire morte ROM (258).

6. Unité de mémoire selon l'une quelconque des revendications précédentes, comportant en outre: une machine à états (251) destinée à produire ledit premier signal de commande d'adresse, ledit premier signal de commande d'écriture et ledit premier signal de commande de lecture.

7. Unité de mémoire selon l'une quelconque des revendications précédentes, dans laquelle ladite matrice de cellules de stockage a une topologie complexe comprenant des paires de lignes binaires torsadées.

8. Unité de mémoire selon l'une quelconque des revendications précédentes, dans laquelle l'unité de mémoire est une unité de mémoire vive (RAM).

9. Unité de mémoire selon l'une quelconque des revendications précédentes, dans laquelle ladite unité d'adressage comporte une unité d'adressage de rangées et de colonnes (233, 223) destinée à l'adressage de cellules de stockage hors rangées; et
une unité d'adressage auxiliaire (254, 255) qui, en réponse à l'adressage de signaux de commande, est destinée à l'adressage d'une série de groupes non séquentiels de matrices de cellules de stockage.

10. Unité de mémoire selon l'une quelconque des revendications précédentes, comportant en outre:
une unité de commande (251) destinée à produire lesdits signaux de commande d'adressage ayant un mode de test pour provoquer l'entrée d'un groupe de données stockées dans une série présélectionnée de groupes non séquentiels de matrices de cellules de stockage.

11. Unité de mémoire selon la revendication 10, comportant en outre:
une unité de comparaison (252) couplée à ladite unité d'entrée/sortie (241) de données et à ladite unité (258) de stockage de motifs, ladite unité de commande (251) ayant un second mode de test pour produire une récupération de groupes de données stockés à partir d'une série de groupes non séquentiels de matrices de cellules de stockage et pour comparer lesdits groupes de données récupérés au groupe de données de motifs stocké à l'origine dans ladite série de groupes non séquentiels de matrices de cellules de stockage.

12. Unité de mémoire selon la revendication 10 ou la revendication 11, dans laquelle une pluralité de ladite série de groupes non séquentiels de matrices de cellules de stockage en combinaison avec une pluralité de groupes de motifs de données permettent à ladite matrice de cellules de stockage d'être remplie d'un motif de matrices présélectionné.

13. Unité de mémoire selon l'une quelconque de la revendication 11 ou de la revendication 12, comportant en outre: une unité (259) de stockage de comparaison destinée à stocker des résultats de ladite comparaison.

14. Unité de mémoire selon l'une quelconque des revendications 11 à 14, dans laquelle ladite unité d'adressage auxiliaire comprend un générateur d'adresse de pas variable.

15. Procédé pour fournir à une matrice de cellules de stockage donnée dans une unité de mémoire un groupe présélectionné de motifs de données, le procédé comprenant:
le stockage dans une sous-unité de ladite unité de mémoire, le groupe de motifs de données comprenant ledit groupe de motifs de données présélectionné; et
l'application de chacun desdits groupes de motifs de données à une série non séquentielle d'adresses de groupes de cellules de stockage.

16. Procédé selon la revendication 15, comprenant en outre:
la récupération de chacun desdits groupes de motifs de données à partir de chacune de ladite série non séquentielle d'adresses de groupes de cellules de stockage; et
la comparaison de chaque groupe de motifs de données récupéré à un groupe de motifs de données dans ladite sous-unité stocké à l'adresse du groupe de cellules de stockage.

17. Appareil de test pour tester une unité de mémoire ayant une matrice de cellules de stockage comportant une pluralité de groupes de cellules de stockage et une unité d'entrée/sortie de données destinée à échanger des données avec un groupe d'adresses et de cellules, ledit appareil de test étant **caractérisé en ce qu'**il comporte:
une unité (258) de mémoire de motifs destinée à stocker une première pluralité de groupes de motifs de données;
une unité d'adressage destinée à adresser une seconde pluralité de groupes non séquentiels de cellules de stockage, des groupes de motifs de données stockés dans des groupes de cellules de stockage associés permettant à un motif de donnée présélectionné ou à une partie de celui-ci d'être introduit dans ladite matrice de cellules de stockage de ladite unité de mémoire.

18. Appareil de test selon la revendication 17, comportant en outre une unité de comparaison (252) destinée à comparer un groupe de mémoires de motifs sélectionné à des groupes de motifs de données récupérés par ladite unité d'adressage à partir de groupes de cellules de stockage dans lesquels ledit motif sélectionné a été stocké.

19. Appareil de test selon la revendication 18, comportant en outre: une unité de stockage de comparaison (259) destinée à stocker des résultats reçus de ladite unité de comparaison (252).

20. Appareil de test selon l'une quelconque des revendications 17 à 19, dans lequel ladite unité d'adressage comprend un générateur (254, 255) d'adresse de pas variable.

21. Appareil de test selon l'une quelconque des revendications 17 à 20, dans lequel l'appareil de test est formé intégralement avec une unité de mémoire.
